## Europäisches Patentamt

## European Patent Office

## Office européen des brevets

(19)

(11) Veröffentlichungsnummer: **0 013 686**
**B1**

(12) **EUROPÄISCHE PATENTSCHRIFT**

(45) Veröffentlichungstag der Patentschrift:
23.06.82

(51) Int. Cl.³: **H 03 K 3/287, G 11 C 11/40**

(21) Anmeldenummer: **79103607.2**

(22) Anmeldetag: **24.09.79**

(54) Verriegelungsschaltung.

(30) Priorität: **26.12.78 US 973426**

(43) Veröffentlichungstag der Anmeldung:
**06.08.80 Patentblatt 80/16**

(45) Bekanntmachung des Hinweises auf die Patenterteilung:
**23.06.82 Patentblatt 82/25**

(84) Benannte Vertragsstaaten:
**DE FR GB**

(56) Entgegenhaltungen:
**DE-B-2 027 991**

(73) Patentinhaber: **International Business Machines Corporation, Armonk, N.Y. 10504 (US)**

(72) Erfinder: **Carter, Eric Lee, 109 Smithfield Dr., Endicott, NY 13760 (US)**
Erfinder: **Nosowicz, Eugene James, 152 Meadowbrook Ln. North, Vestal, NY 13850 (US)**

(74) Vertreter: **Böhmer, Hans Erich, Dipl.-Ing., Schönaicher Strasse 220, D-7030 Böblingen (DE)**

## Verriegelungsschaltung

Die Erfindung betrifft eine durch Einstell- bzw. Rückstellimpulse unabhängig von Taktimpulsen umsteuerbare selbsthaltende bistabile Verriegelungsschaltung, bestehend aus einem ersten und einem zweiten Transistor, von denen immer einer leitend und einer gesperrt ist, einem daran angekoppelten, über eine Dateneingangsleitung ansteuerbaren dritten Transistor und einem damit in Reihe geschalteten über eine Taktimpulsleitung ansteuerbaren vierten Transistor und einem fünften durch ein Bezugspotential ansteuerbaren Transistor, in welcher Schaltung ein binäres Datensignal bei Auftreten eines Taktimpulses die bistabile Schaltung an ihrem Ausgang auf das entsprechende binäre Ausgangssignal einzustellen vermag.

Durch Taktimpulse angesteuerte Verriegelungsschaltungen sind aus dem Stand der Technik als bistabile Schaltungen bekannt, denen eingangsseitig sowohl Taktimpulse als auch Datensignale zugeführt werden, an deren Ausgang sich ein gegebener Zustand so lange nicht ändert, bis eingangsseitig ein Taktsignal auftritt. Es ist oft erwünscht, solche Schaltungen auch noch mit einem Einstelleingang und einem Rückstelleingang zu versehen, so daß das am Ausgang der Schaltung auftretende Signal in einen bekannten logischen Zustand überführt werden kann, ohne daß dazu eingangsseitig ein Taktsignal zugeführt werden muß. Normalerweise wird eine solche Einstell-/Rückstellmöglichkeit nur auf Kosten weiterer Bauelemente und eines zusätzlichen Leistungsbedarfs erkauft. Außerdem erfordern diese zusätzlichen logischen Elemente, daß beim Entwurf de Schaltung auf mögliche Selbsterregung geachtet wird, um sicher zu sein, daß sich die Verriegelungsschaltung immer dann umschalten läßt, wenn dies gewünscht wird.

Daher ist es als Aufgabe der Erfindung anzusehen, eine Verriegelungsschaltung dieser Art zu schaffen, in der die schaltungsmäßige Möglichkeit für eine vom Auftreten von Taktimpulsen unabhängige Einstellung und Rückstellung mitintegriert ist. Dabei soll in jedem Fall sichergestellt sein, daß sich die Schaltung nicht selbst erregen kann. Selbstverständlich kommt es dabei darauf an, daß die gesamte Schaltung in integrierter Schaltungstechnik auf einem Halbleiterplättchen verwirklicht werden kann.

Dies wird erfindungsgemäß dadurch erreicht, daß ein sechster Transistor zur Reihenschaltung des dritten und vierten Transistors parallel geschaltet an einem der ersten beiden Transistoren der bistabilen Schaltung angeschlossen und über eine Eingangsklemme mit einem Einstellsignal ansteuerbar ist und daß ein siebter Transistor an dem anderen der ersten beiden Transistoren angeschlossen und zur Reihenschaltung des vierten Transistors mit dem fünften durch ein Bezugspotential ansteuerbaren Transistor parallel geschaltet und an einer Eingangsklemme mit einem Rückstellsignal ansteuerbar ist, so daß damit die bistabile Schaltung unabhängig von Taktimpulsen durch die Einstell- bzw. Rückstellsignale in ihren entsprechenden Betriebszustand umschaltbar ist.

Die Erfindung wird nunmehr anhand eines Ausführungsbeispiels in Verbindung mit den Zeichnungen im einzelnen näher erläutert.

In den Zeichnungen zeigt

Fig. 1 schematisch ein Blockschaltbild einer Verriegelungsschaltung, bei der die Möglichkeit einer zusätzlichen Einstellung und Rückstellung durch zusätzliche äußere logische Schaltelemente erreicht ist,

Fig. 2 Einzelheiten eines Blockschaltbilds der bekannten Verriegelungsschaltung,

Fig. 3 ein verallgemeinertes Blockschaltbild der Verriegelung gemäß der Erfindung und

Fig. 4 ein Schaltbild der in Fig. 3 nur schematisch angedeuteten Verriegelungsschaltung.

### Beschreibung der bevorzugten Ausführungsform der Erfindung

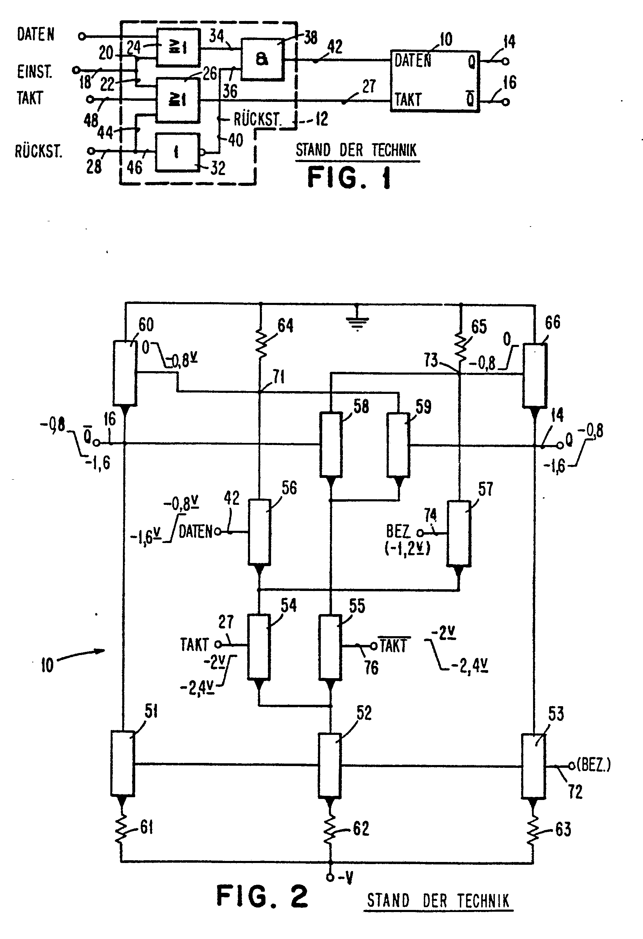

In den Figuren der Zeichnungen sind zur Kennzeichnung gleicher Teile stets die gleichen Bezugszeichen verwendet worden. Fig. 1 zeigt dabei eine mögliche Art des Standes der Technik mit einer Kaskoden-Verriegelungsschaltung 10, bei der es eine zusätzliche Einstell-/Rückstellmöglichkeit durch Verwendung zusätzlicher externer logischer Schaltungen 12 gibt. Diese Kaskoden-Verriegelungsschaltung 10 ist im einzelnen in Fig. 2 dargestellt.

Diese Einstell-/Rückstellmöglichkeit wird zusätzlich für die Verriegelungsschaltung 10 vorgesehen, damit sie nach dem Einschalten oder aber zu jedem beliebigen Zeitpunkt auf ein vorbestimmtes logisches Ausgangssignal eingestellt werden kann. Es sei hier übereingekommen, daß bei Einstellung der Verriegelungsschaltung 10 am Q-Ausgang eine logische Eins auftritt, während ein Rückstellsignal zur Folge hat, daß am $\bar{Q}$-Ausgang eine logische Null auftritt. Die am Q-Ausgang angeschlossene Ausgangsleitung 16 nimmt dann zwangsläufig jeweils den entgegengesetzten logischen Zustand der zwei möglichen logischen Zustände der am Q-Ausgang angeschlossenen Ausgangsleitung 14 an.

Ferner soll die Anwesenheit eines Impulses bedeuten, daß die Eingangsleitung, auf der dieser Impuls auftritt, auf einer logischen Eins liegt. Die Abwesenheit eines Impulses bedeutet dann, daß die Eingangsleitung auf einer logischen Null liegt. Ferner soll bei der Beschreibung der Arbeitsweise der Verriegelungsschaltungen 10 und 10' angenommen werden, daß beim Einstell-/Rückstellbetrieb ein Taktimpuls nicht vorhanden ist.

Diese bekannte Schaltung arbeitet dabei wie folgt: Es sei zunächst für die Erläuterung angenommen, daß die Verriegelungsschaltung eingeschaltet ist, wobei der logische Zustand der Ausgangsleitungen nicht vorhersehbar ist. Zu diesem Zeitpunkt sei ferner angenommen, daß die am Q-Ausgang der Verriegelungsschaltung angeschlossene Ausgangsleitung 14 auf einer logischen Eins liegen soll. Dies wird dadurch erreicht, daß die Einstelleitung 18 erregt wird und damit auf logisch Eins liegt. Wenn dies eintritt, dann liegen die Eingangsleitungen 20 und 22 der ODER-Glieder 24 bzw. 26 auf logisch Eins. Es sei darauf hingewiesen, daß die Takteingangsleitung 27 erst nach einer Verzögerung um eine Stufe, die zwangsläufig durch das ODER-Glied 26 eingeführt wird, durch das Einstellsignal entsperrt wird.

Liegt auf der Leitung 28 kein Rückstellsignal, dann wird eine logische Null nach der Inverterstufe 32 übertragen, was zur Folge hat, daß die Rückstellen-Leitung 40 auf logisch Eins gebracht wird. Das hat wiederum zur Folge, daß am zweiten Eingang 36 des UND-Glieds 38 eine logische Eins liegt. Da die andere Eingangsleitung 34 des UND-Glieds 38 bereits auf logisch Eins liegt, wird das UND-Glied 38 entsperrt und stellt damit die Dateneingangsleitung 42 der Verriegelungsschaltung 10 auf eine logische Eins. Es sei vermerkt, daß die Dateneingangsleitung 42 nach zwei Stufen Verzögerung, die zwangsläufig durch das UND-Glied 38 in Verbindung mit dem ODER-Glied 24 eingeführt werden, durch das Einstellsignal entsperrt wird.

Da der Signalzustand der Datenleitung 42 zum Zeitpunkt der Hinterkante des logischen Signals auf der Taktleitung 26 dem Signal entspricht, das auf der am Q-Ausgang der Verriegelungsschaltung 10 angeschlossenen Ausgangsleitung 14 auftritt, so ist es zwingend erforderlich, daß beim Entwurf der Schaltung die richtige zeitliche Zuordnung der einzelnen Impulse eingehalten wird. Unglücklicherweise haben die Datensignale und die Takteingangssignale denselben Ursprung, nämlich das Einstellsignal, durchlaufen jedoch unterschiedliche Übertragungsstufen. Es ist daher notwendig, beim Entwurf einer Schaltung mögliche Selbsterregungsbedingungen aus Daten- und Taktimpulsen zu berücksichtigen und mit geeigneten Mitteln auszuschließen.

Das Rückstellsignal, das auf der am Q-Ausgang angeschlossenen Ausgangsleitung 14 eine logische Null zur Folge hat, stellt beim Entwurf der Schaltung die gleiche Schwierigkeit dar. Wenn beim Rückstellen die Leitung 28 auf eine logische Eins gebracht wird, dann geht auch die Eingangsleitung 44 des ODER-Gliedes 26 und die Eingangsleitung 46 der Inverterstufe 32 auf eine logische Eins. Die Rückstellen-Leitung 40 und die Eingangsleitung 36 des UND-Gliedes 38 liegen daher auf einer logischen Null. Da an mindestens einer der beiden Eingangsleitungen des UND-Gliedes 38 nunmehr eine logische Null liegt, ist dieses UND-Glied gesperrt, so daß die Datenleitung 42 der Verriegelungsschaltung 10 auf einer logischen Null liegt. Das ODER-Glied 26 wird durch die auf der Eingangsleitung 44 liegende logische Eins entsperrt und liefert damit ein eine logische Eins darstellendes Signal auf der Takteingangsleitung 27 an die Verriegelungsschaltung 10. Die Takteingangsleitung 48 hat die Aufgabe, normale Durchschaltimpulse an diese Schaltung abzugeben.

Wiederum gehen die auf der Datenleitung und der Takteingangsleitung auftretenden Signale von der gleichen Stelle und zum gleichen Zeitpunkt aus, durchlaufen jedoch unterschiedliche Stufen der Übertragung. Daher ist eine typische Schaltung dieser Art mit der Möglichkeit einer Einstellung/Rückstellung für eine Kaskoden-Verriegelungsschaltung auf die Möglichkeit zu untersuchen, daß sich aus Daten und Taktimpulsen keine Möglichkeit für eine Selbsterregung ergibt, unabhängig von der Betriebsart, d. h. ob Einstellen oder Rückstellen durchgeführt werden soll. Ferner sei darauf hingewiesen, daß diese zusätzliche Möglichkeit mindestens vier zusätzliche Schaltungsgruppen erfordert.

Eine typische Kaskoden-Verriegelungsschaltung ist in Fig. 2 dargestellt. Es sei wiederum angenommen, daß die Verriegelungsschaltung 10 eingeschaltet ist und daß auf der am Q-Ausgang angeschlossenen Ausgangsleitung 14 eine logische Eins liegt. Unabhängig vom Verriegelungszustand wirken die Transistoren 51, 52 und 53 mit den Widerständen 61, 62 bzw. 63 als Stromquellen für jeden der drei Stromzweige der Verriegelungsschaltung 10. Die Transistoren 60 und 66 sind daher ständig eingeschaltet und dienen der Pegelumsetzung, wie dies noch erläutert wird.

Ist die Verriegelungsschaltung 10 eingeschaltet und liegt die Taktsignalleitung 27 auf einer logischen Null und demgemäß die am Q-Ausgang angeschlossene Ausgangsleitung 14 auf einer logischen Eins, dann ist der Transistor 59 aus dem die eigentliche Verriegelungsschaltung darstellenden Transistorpaar 58, 59 eingeschaltet. Da die Taktsignalleitung 27 auf einer logischen Null liegt, liegt die dazu komplementäre Eingangsleitung 76 auf einer logischen Eins, Das bedeutet, daß der von den Transistoren 52 und 55 kommende Strom nach dem Transistor 59 umgeleitet wird, wodurch der Knotenpunkt 71 auf niedrigem Potential und der Knotenpunkt 73 auf hohem Potential gehalten wird. Der über den Widerstand 64 fließende Strom verursacht einen Spannungsabfall, wodurch das Potential am Knotenpunkt 71 auf einem kleineren Wert gehalten wird, als das am Knotenpunkt 73 liegende Potential. Wenn das Potential am Knotenpunkt 73 hoch ist, dann ist auch das Potential an der Basiselektrode des Transistors 66 hoch, was zur Folge hat, daß das Potential an dessen Emitterelektrode, die am Q-Ausgang mit Ausgangsleitung 14 angeschlossen ist, höher ist, als das Potential an der Emitterelektrode des Transistors 60, welche über den Q̄-Ausgang an der Ausgangsleitung 16 angeschlossen ist. Diese Potentialdifferenz, die in Fig. 2 angedeutet ist, ist im wesentlichen der Spannungsabfall über dem Widerstand 64.

Wenn anschließend auf der Takteingangsleitung 27 ein Taktimpuls aufgenommen wird, dann wird der Transistor 54 eingeschaltet und der mit TAKT bezeichnete Transistor 55 wird gesperrt. Ist zu diesem Zeitpunkt auf der Dateneingangsleitung 42 kein Datenimpuls vorhanden, dann wird der Strom über den Bezugsspannungstransistor 57 umgeleitet, wodurch das Potential am Knotenpunkt 73 niedrig und das Potential am Knotenpunkt 71 hoch wird. Wenn das Potential am Knotenpunkt 73 abfällt, was bedeutet, daß Strom über den Widerstand 65 gezogen wird, dann weist Transistor 66 an seiner Emitterelektrode ein niedriges Potential auf, wodurch die am Q-Ausgang angeschlossene Ausgangsleitung 14 auf eine logische Null geht. Wenn daher die Taktimpulsleitung 27 bei Abwesenheit eines Datenimpulses angesteuert wird, dann wird die am Q-Ausgang angeschlossene Ausgangsleitung 14 der Verriegelungsschaltung 10 in einem logischen Zustand eingestellt, der dem logischen Zustand der Datenimpulsleitung 42 entspricht. Dadurch wird bei Abfallen des Taktimpulses der Transistor 58 eingeschaltet und die beiden Transistoren der Verriegelungsschaltung werden solange in diesem Betriebszustand gehalten, wie die Knotenpunkte 71 und 73 auf ihren jeweiligen Potentialen gehalten werden.

Wenn während der Anwesenheit eines Taktimpulses ein Datenimpuls aufgenommen wird, dann wird der Transistor 56 eingeschaltet und der Strom durchfließt nun die Transistoren 54 und 56, worauf der Knotenpunkt 71 auf ein niedriges Potential und Knotenpunkt 73 auf ein hohes Potential geht. Dadurch wird der Betriebszustand der Verriegelungsschaltung umgeschaltet, so daß an der am Q-Ausgang angeschlossenen Ausgangsleitung 14 eine logische Eins erscheint, wobei dieser Betriebszustand beibehalten wird, wenn das Taktimpulssignal wegfällt.

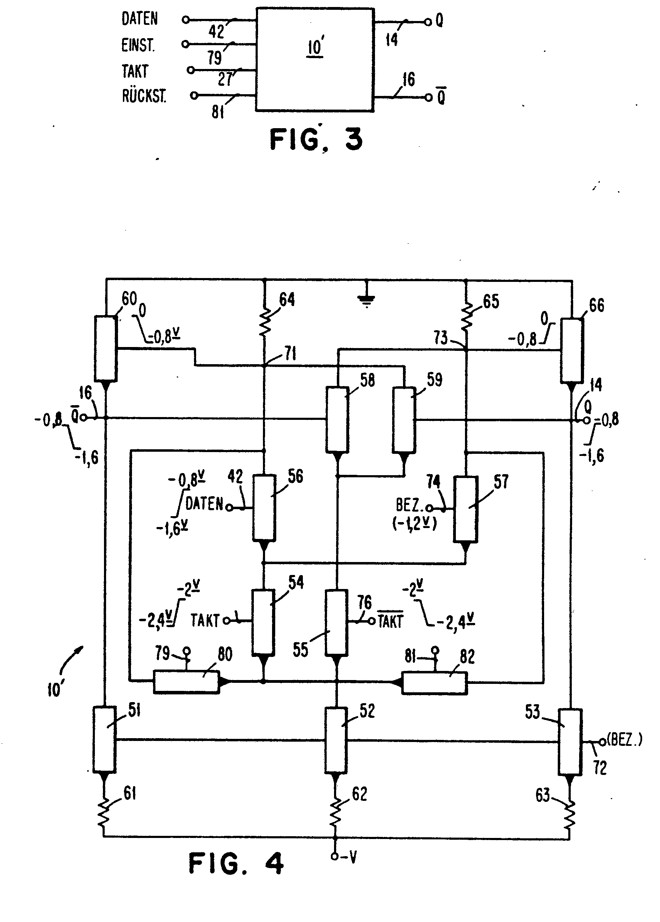

Eine Kaskoden-Verriegelungsschaltung 10' mit integrierter Möglichkeit für Einstellen/Rückstellen zeigt ganz allgemein Fig. 3. Obgleich es aus dieser Figur nicht unmittelbar ersichtlich ist, benötigt die Verriegelungsschaltung 10' keine zusätzliche Stromversorgung, noch gibt es zusätzliche Verzögerungen, die zu der der Grundschaltung bereits eigenen Verzögerung hinzukämen. Außerdem benötigt die integrierte Verriegelungsschaltung 10' nicht so viele Bauelemente wie die in Fig. 1 dargestellte bekannte Schaltung.

Fig. 4 zeigt eine mehr ins einzelne gehende Darstellung der Verriegelungsschaltung 10', die etwa so arbeitet wie die in Fig. 2 dargestellte Verriegelungsschaltung 10, jedoch mit einigen Ausnahmen. Neu hinzugekommen sind die Transistoren 80 und 82. Die an der Basiselektrode des Transistors 80 angeschlossene Eingangsleitung 79 dient als Einstelleitung und die an der Basiselektrode des Transistors 82 angeschlossene Eingangsleitung 81 als Rückstelleitung für die Verriegelungsschaltung 10'. Der Transistor 80 überbrückt dabei die in Reihe geschalteten Transistoren 54 und 56, so daß das Auftreten eines Einstellimpulses bewirkt, daß die Verriegelungsschaltung 10' so arbeitet, als ob die Transistoren 54 und 56 eingeschaltet wären. Das bedeutet, daß bei Einschalten des Transistors 80 der Knotenpunkt 71 auf ein niedriges Potential gebracht wird und am Q-Ausgang auf der Ausgangsleitung 14 eine logische Eins erscheint. Andererseits ist der Transistor 82 parallel zu den Transistoren 54 und 57 geschaltet und bewirkt bei seiner Einschaltung durch einen Rückstellimpuls, daß die Verriegelungsschaltung 10' genauso arbeitet, wie wenn die Transistoren 54 und 57 eingeschaltet wären. Dies bedeutet, daß bei eingeschaltetem Transistor 82 der Knotenpunkt 73 auf niedriges Potential gebracht wird, und die am Q-Ausgang angeschlossene Ausgangsleitung 14 eine logische Null aufweist.

Während des Auftretens eines Einstell- oder Rückstellimpulses auf Leitung 79 bzw. 81 sind die Transistoren 58 und 59 zwar in Durchlaßrichtung vorgespannt, sind jedoch nicht leitend.

Wenn der Einstell- oder Rückstellimpuls abfällt, dann wird entweder der Transistor 80 oder Transistor 82 gesperrt und es fließt ein Strom über den Transistor 55. Das hat zur Folge, daß der Transistor 59 der Verriegelungsschaltung eingeschaltet wird. Der Betriebszustand der Verriegelungsschaltung 10' bleibt danach erhalten, wie dies beispielsweise in Abhängigkeit von einem Einstell- oder Rückstellimpuls festgelegt wurde, bis ein weiteres Entsperrsignal ankommt. Das höchste an der Basiselektrode der Transistoren 54, 55, 80 oder 82 anliegende Potential bestimmt daher den Stromkreis, der schließlich die bei Q bzw. Q̄ angeschlossenen Ausgangsleitungen 14 bzw. 16 auf den gewünschten logischen Zustand bringt. Es sei darauf hingewiesen, daß das Potential des Einstell- bzw. Rückstellimpulses vorzugsweise höher gewählt wird, als die Potentialdifferenz des Taktsignals, in diesem Fall 400 mV. Wenn daher entweder der Einstell- oder Rückstellimpuls vorhanden ist, dann wird dadurch ein Taktimpuls oder ein Dateneingangsimpuls, falls vorhanden, übersteuert, worauf die Verriegelungsschaltung 10' entsprechend umschaltet. Fällt das Einstell- oder Rückstellsignal ab, dann schaltet die Verriegelungsschaltung 10' wieder um, und die Takteingangsleitung 27 kann wieder ihre normale Funktion als Eingangsleitung für die Verriegelungsschaltung übernehmen.

Da die Möglichkeit zur Einstellung und Rückstellung erzielt wird, ohne daß dabei die bei der Taktgabe oder beim Dateneingang verwendeten Bauelemente davon betroffen sind, muß beim Entwurf der Schaltung auch nicht auf eine mögliche Selbsterregung geachtet werden. Die nötigen Spannungspegel für Einstell- und Rückstellimpulse lassen sich durch mit Hilfe von Dioden verschobenen Potentialen auf dem Chip erzielen. Dies wird in einfacher Weise dadurch erreicht, daß in der Ausgangs-Emitterfolgestufe einer Treiberschaltung eine Diode angeordnet wird.

## Patentanspruch

Durch Einstell- bzw. Rückstellimpulse unabhängig von Taktimpulsen umsteuerbare selbsthaltende bistabile Verriegelungsschaltung, bestehend aus einem ersten und einem zweiten Transistor (58, 59), von denen immer einer leitend und einer gesperrt ist, einem daran angekoppelten, über eine Dateneingangsleitung (42) ansteuerbaren dritten Transistor (56) und einem damit in Reihe geschalteten über eine Taktimpulsleitung (27) ansteuerbaren) vierten Transistor (54) und einem fünften durch ein Bezugspotential (74) ansteuerbaren Transistor (57), in welcher Schaltung ein binäres Datensignal bei Auftreten eines Taktimpulses die bistabile Schaltung an ihrem Ausgang (Q, Q̄) auf das entsprechende, binäre Ausgangssignal einzustellen vermag, dadurch gekennzeichnet, daß ein sechster Transistor (80) zur Reihenschaltung des dritten und vierten Transistors (56, 54) parallel geschaltet an einem der ersten beiden Transistoren (58, 59) der bistabilen Schaltung angeschlossen und über eine Eingangsklemme (79) mit einem Einstellsignal ansteuerbar ist und daß ein siebter Transistor (82) an dem anderen der ersten beiden Transistoren (58, 59) angeschlossen und zur Reihenschaltung des vierten Transistors (54) mit dem fünften durch ein Bezugspotential (74) ansteuerbaren Transistor (57) parallel geschaltet und an einer Eingangsklemme (81) mit einem Rückstellsignal ansteuerbar ist, so daß damit die bistabile Schaltung (10′) unabhängig von Taktimpulsen durch die Einstellbzw. Rückstellsignale in ihren entsprechenden Betriebszustand umschaltbar ist.

## Claim

Bistabile latch switchacle by means of set and reset pulses independently of clock pulses, comprising a first and a second transistor (58, 59) one of which being always conductive and one non-conductive, and a third transistor (56) coupled thereto an addressable via a data input line (42), and a fourth transistor (54) arranged in series therewith and addressable via a clock pulse line (27), and a fifth transistor (57) addressable through a reference potential (74), in which circuit a binary data signal can set the bistable circuit at its output (Q, Q̄) to the respective binyry output signal, characterized in that to the series-connection of the third and fourth transistor (56, 54) a sixth transistor (80) is connected in parallel and to one of the two first transistors (58, 59) of the bistable circuit, and addressable via an input terminal (79) to a set signal, and that a seventh transistor (82) is connected to the other one of the first two transistors (58, 59), and arranged in parallel to the series connection of the fourth transistor (54) and the fifth transistor (57) that is biased by means of a reference potential (74), said seventh transistor (82) being addressable at an input terminal (81) with a reset signal, so that independently of clock pulses the biastable circuit (10′) can be switched into its corresponding operating state by means of the set and reset pulses.

## Revendication

Bascule bistable à auto-maintien pouvant être commutée par des impulsions de déclenchement et de restauration, indépendamment des impulsions de chronologie, qui comporte un premier et un second transistor (58, 59) dont l'un est toujours conducteur et l'autre bloqué, un troisième transistor (56) couplé avec ceux-ci pouvant être commuté par une ligne d'entrée et de données (42) et un quatrième transistor (54) connecté en séries avec ce transistor et pouvant être commuté par une ligne d'impulsion de chronologie (27), ainsi qu'un cinquième transistor (57) pouvant être commuté par un potential de référence (74), circuit dans lequel, lors de l'application d'une impulsion de chronologie, un signal de données binaires peut déclencher le circuit bistable avec le signal de sortie binaire correspondant à sa sortie (Q, Q̄), caractérisée en ce qu'un sixième transistor (80), connecté en parallèle avec le circuit en série des troisième et quatrième transistors (56, 54) et connecté à l'un des deux premiers transistors (58, 59) de la bascule bistable, peut être commuté par un signal de déclenchement à travers une borne d'entrée (79), et en ce qu'un septième transistor (82), connecté à l'autre des deux premiers transistors (58, 59) et connecté en parallèle avec le circuit en série des quatrième (54) et cinquième transistors (57) ce dernier pouvant être commuté par un potential de référence (74), peut être commuté par un signal de restauration à une borne d'entrée (81) de telle sorte que, indépendamment des impulsions de chronologie, la bascule bistable (10′) peut être commutée dans ses états respectifs de fonctionnement par les signaux de déclenchement ou de restauration.

STAND DER TECHNIK
## FIG. 1

## FIG. 2    STAND DER TECHNIK

FIG. 3

FIG. 4